(19) Europäisches Patentamt / European Patent Office / Office européen des brevets

(11) **EP 4 761 532 A1**

(12) **EUROPEAN PATENT APPLICATION**
published in accordance with Art. 153(4) EPC

(43) Date of publication:
**17.06.2026  Bulletin 2026/25**

(51) International Patent Classification (IPC):
*H10H 29/20* (2026.01)    *H10H 20/855* (2025.01)
*H10H 20/85* (2025.01)    *H10H 29/01* (2025.01)

(21) Application number: 24854483.5

(52) Cooperative Patent Classification (CPC):
**H10H 20/855; H10H 29/855**

(22) Date of filing: **16.08.2024**

(86) International application number:
**PCT/KR2024/012198**

(87) International publication number:
**WO 2025/037932 (20.02.2025 Gazette 2025/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 17.08.2023  US 202363533177 P
05.06.2024  US 202463656215 P
13.08.2024  US 202418802234

(71) Applicant: **Seoul Semiconductor Co., Ltd.
Gyeonggi-do 15429 (KR)**

(72) Inventors:
• **LEE, Jang Weon**
**Ansan-si Gyeonggi-do 15429 (KR)**
• **HWANG, Sung Ki**
**Ansan-si Gyeonggi-do 15429 (KR)**
• **KWAK, Meen Woo**
**Ansan-si Gyeonggi-do 15429 (KR)**

(74) Representative: **Stolmár & Partner
Patentanwälte PartG mbB
Blumenstraße 17
80331 München (DE)**

(54) **LIGHT-EMITTING MODULE AND DISPLAY DEVICE COMPRISING SAME**

(57)    According to one aspect of the present disclosure, there may be provided a light-emitting module including: a light emitting device that generates light; a lens disposed above the light emitting device to collect light generated from the light emitting device; and a partition extending in an up-down direction to surround at least a portion of the first lens.

*FIG.3*

I – I'

EP 4 761 532 A1

## Description

### TECHNICAL FIELD

The present disclosure relates to a light emitting module and a display device including the same.

### BACKGROUND ART

A display device is a device that displays characters, symbols, images, or videos. The display device includes a plurality of light emitting modules, and the light emitting modules include a plurality of light emitting devices that generate light, and the plurality of light emitting devices may generate the same color or different colors. The display device can control light generated from the plurality of light emitting devices to display characters, symbols, images, or videos.

The light emitting device may include a light emitting diode (LED) that generates light when supplied with electricity. The LEDs have the advantages of high efficiency, low power, and long lifespan, so they have been widely used as light emitting devices in recent years. In addition, the LEDs are becoming increasingly miniaturized into mini LEDs and micro LEDs.

Since the LED has a predetermined beam angle and the amount of light decreases as the size becomes smaller, the luminance, which indicates the degree of brightness per unit area, may be reduced. In other words, when the light emitting device is a small LED such as a micro LED or mini LED, the luminance may be reduced compared to when a relatively large LED is used. Therefore, it has been difficult to implement a high-resolution, high-brightness display device using small LEDs as light emitting devices.

### DETAILED DESCRIPTION OF INVENTION

### TECHNICAL PROBLEMS

Embodiments of the present disclosure are conceived based on the above background, and provide a light emitting module capable of improving luminance even if the size of a light emitting device is reduced, and a display device including the light emitting module.

### MEANS FOR SOLVING PROBLEMS

According to an aspect of the present disclosure, there may be provided a light emitting module including: a light emitting device that generates light; a first lens disposed above the light emitting device to collect light generated from the light emitting device; and a partition member extending in an up-down direction to surround at least a portion of the first lens.

Further, there may be provided a light emitting module further including a first lens support member disposed between the light emitting device and the first lens to allow light to pass therethrough while supporting the first lens.

Further, there may be provided the light emitting module further including a second lens disposed above the first lens to collect light passing through the first lens and having a downwardly convex shape; and a second lens support member supporting the second lens and through which light passing through the second lens is transmitted.

Further, there may be provided the light emitting module in which the first lens has an upwardly convex shape, and the second lens has a downward convex shape, and a first lens angle of a first virtual line connecting an uppermost point of the first lens and an outer edge of a bottom of the first lens with respect to the first lens support member and a second lens angle of a second virtual line connecting a lowermost point of the second lens support member and an outer edge of a top of the second lens with respect to the second lens support member are formed differently from each other.

Further, there may be provided the light emitting module further including: an element support member disposed below the first lens support member and having an element support hole through which the light emitting device is inserted and supported.

Further, there may be provided the light emitting module in which a width of a bottom of the first lens and a height of the first lens are greater than a height of the first lens support member.

Further, there may be provided the light emitting module in which an angle of a first lens tangent passing through an outer edge of a bottom of the first lens with respect to the first lens support member and an angle of the second lens tangent passing through an outer edge of a top of the second lens with respect to the second lens support member are formed differently from each other.

Further, there may be provided the light emitting module in which the first lens and the second lens are in contact with each other.

Further, there may be provided the light emitting module in which the partition member forms a lens accommodation space in which the first lens is accommodated, and a ratio of a width of the bottom of the first lens and a width of the lens accommodation space is 1:1 to 1:1.5 or less.

Further, there may be provided the light emitting module in which the first lens and the second lens are arranged to be spaced apart from each other.

Further, there may be provided the light emitting module in which a width of the partition member is less than or equal to a height of the partition member.

Further, there may be provided the light emitting module in which the light emitting device includes: a light emitting diode chip that generates light; and a light-transmissive substrate disposed above the light emitting diode chip and through which the light transmits, wherein a height of the first lens support member is greater than a height of the light emitting diode chip, a height of the light-transmitting substrate is greater than a height of the first lens support member, and the height of the first lens is greater than the height of the first lens support member.

Further, there may be provided the light emitting module in which the light emitting device includes: a light emitting diode chip that generates light; and a light-transmissive substrate through which the light transmits, and a refractive index of the light-transmitting substrate is greater than a refractive index of the first lens and a refractive index of the first lens support member.

Further, there may be provided the light emitting module in which a width of the partition member becomes smaller as it goes upward.

Further, there may be provided the light emitting module in which an angle formed by the first lens support member and the partition member is 60 degrees to 90 degrees.

Further, there may be provided the light emitting module in which the partition member has an upwardly convex shape, and an angle of a first imaginary line connecting an uppermost point of the partition member and an outer edge of a bottom of the partition member with respect to the first lens support member is greater than an angle of a second imaginary line connecting an uppermost point of the first lens and an outer edge of the bottom of the first lens with respect to the first lens support member.

Further, there may be provided the light emitting module in which the first lens, the first lens support member, and the partition member are formed integrally with each other.

Further, there may be provided the light emitting module in which a convex portion and a concave portion are formed on an upper part of the first lens.

Further, there may be provided a display device including: a light emitting device that emits light; a lens disposed above the light emitting device to collect light generated from the light emitting device; a first lens support member disposed between the light emitting device and the first lens to support the first lens and allow the light to pass therethrough; and a partition member that extends in an up-down direction to surround at least a portion of the first lens and reflects the light, wherein the first lens and the first lens support member are formed integrally with each other, and the partition member is formed separately from the first lens and the first lens support member, or the first lens support member and the partition member are formed integrally with each other, and the first lens is formed separately from the first lens support member and the partition member.

Further, there may be provided a display device including: a display substrate on which an electrical circuit is disposed; and a plurality of light emitting modules disposed on the display substrate to be electrically connected to the electric circuit, wherein the light emitting module includes: a light emitting device that generates light; a first lens disposed above the light emitting device to collect light generated from the light emitting device; a partition member that extends in an up-down direction to surround at least a portion of the first lens and reflects the light; and a second lens disposed above the first lens to collect light passing through the first lens.

## EFFECTS OF INVENTION

According to the embodiments of the present disclosure, the luminance of the light emitting module can be improved even if the size of the light emitting device is reduced.

According to the embodiments of the present disclosure, it is possible to implement a high-resolution, high-brightness display device with a small-sized light emitting device.

## BRIEF DESCRIPTION OF DRAWINGS

FIG. 1 is a perspective view showing a portion of a display device and a light emitting module according to a first embodiment of the present disclosure.
FIG. 2 is an exploded perspective view of a portion of the display device and the light emitting module according to the first embodiment of the present disclosure.

FIG. 3 is a cross-sectional view taken along line I-I' in FIG. 1.

FIG. 4 is an enlarged view of part A in FIG. 3.

FIG. 5 is a cross-sectional view of a light emitting module according to a second embodiment of the present disclosure.

FIG. 6 is a cross-sectional view of a light emitting module according to a third embodiment of the present disclosure.

FIG. 7 is a cross-sectional view of a light emitting module according to a fourth embodiment of the present disclosure.

FIGS. 8 and 9 are cross-sectional views of a light emitting module according to a fifth embodiment of the present disclosure.

FIG. 10 is a cross-sectional view of a light emitting module according to a sixth embodiment of the present disclosure.

FIG. 11 is a cross-sectional view of a light emitting module according to a seventh embodiment of the present disclosure.

FIG. 12 is a cross-sectional view of a light emitting module according to an eighth embodiment of the present disclosure.

FIG. 13 is a perspective view showing a portion of a display device and a light emitting module according to a ninth embodiment of the present disclosure.

FIG. 14 is an exploded perspective view of a portion of the display device and the light emitting module according to the ninth embodiment of the present disclosure.

FIG. 15 is a cross-sectional view taken along line I-I' in FIG. 13.

FIG. 16 is an enlarged view of part A in FIG. 15.

FIG. 17 is a view showing a refractive index of a first lens and a second lens of the light emitting module of FIG. 16.

FIC. 18 is a cross-sectional view showing an example of the light emitting module according to a tenth embodiment of the present disclosure.

FIG. 19 is a cross-sectional view showing another example of the light emitting module according to the tenth embodiment of the present disclosure.

FIG. 20 is a cross-sectional view of a light emitting module according to an eleventh embodiment of the present disclosure.

FIC. 21 is a cross-sectional view showing an example of a light emitting module according to a twelfth embodiment of the present disclosure.

FIG. 22 is a cross-sectional view showing another example of the light emitting module according to the twelfth embodiment of the present disclosure.

FIG. 23 is a plan view showing an example of light emitting modules arranged on a plurality of substrate regions when a display device according to a thirteenth embodiment of the present disclosure is viewed from above.

FIG. 24 is a plan view showing another example of light emitting modules arranged on a plurality of substrate regions when the display device according to the thirteenth embodiment of the present disclosure is viewed from above.

FIG. 25 is a cross-sectional view of a light emitting module according to a fourteenth embodiment of the present disclosure.

FIG. 26 is a cross-sectional view of a light emitting module according to a fifteenth embodiment of the present disclosure.

FIG. 27 is a cross-sectional view of a light emitting module according to a sixteenth embodiment of the present disclosure.

## BEST MODE FOR CARRYING OUT INVENTION

Hereinafter, specific embodiments for implementing a spirit of the present disclosure will be described in detail with reference to the drawings.

In describing the present disclosure, detailed descriptions of known configurations or functions may be omitted to clarify the present disclosure.

When an element is referred to as being 'connected' to, 'supported' by, or 'supplied' to another element, it should be understood that the element may be directly connected to, supported by, or supplied to another element, but that other elements may exist in the middle.

The terms used in the present disclosure are only used for describing specific embodiments, and are not intended to limit the present disclosure. Singular expressions include plural expressions unless the context clearly indicates otherwise.

Further, in the present disclosure, it is to be noted that expressions, such as upward, lateral, upper side, lower side, and up and down direction are described based on the illustration of drawings, but may be modified if directions of corresponding objects are changed. For the same reasons, some components are exaggerated, omitted, or schematically illustrated in the accompanying drawings, and the size of each component does not fully reflect the actual size.

Terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

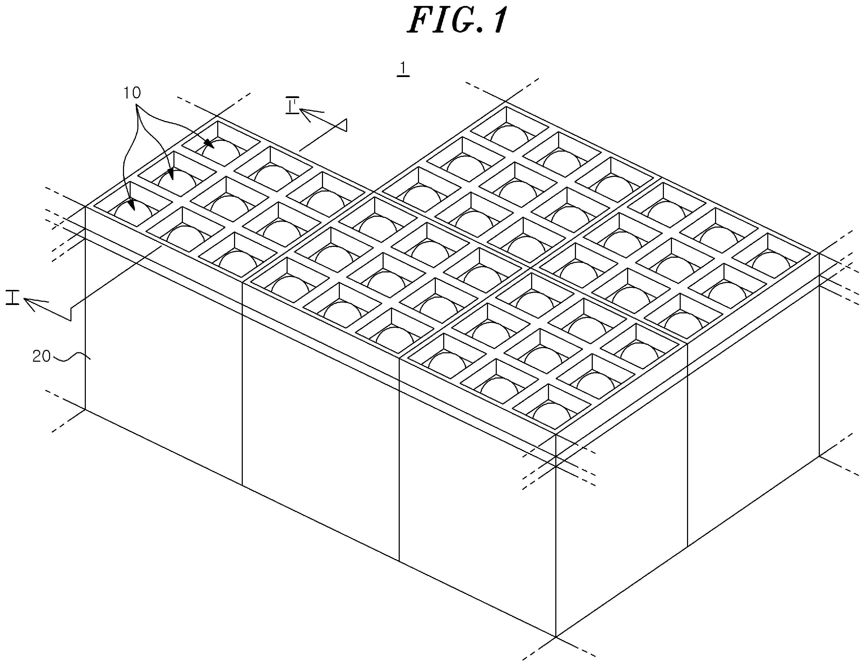

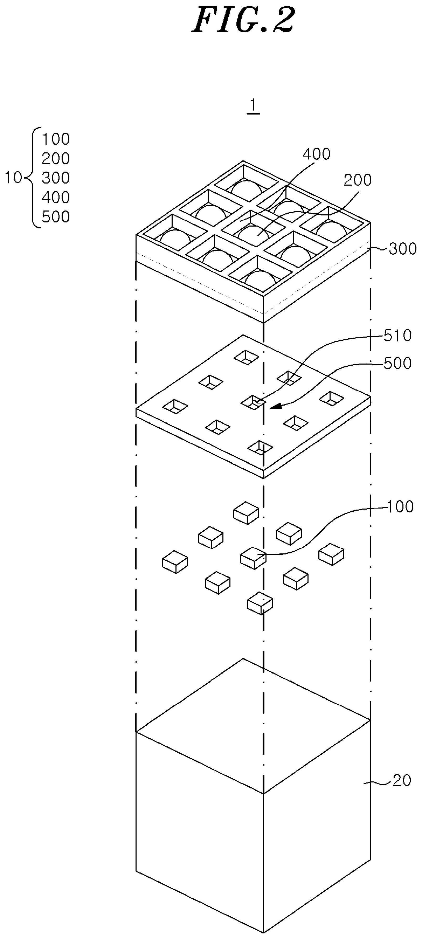

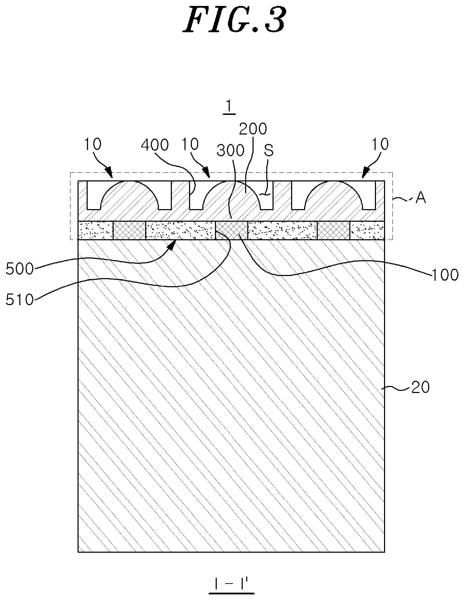

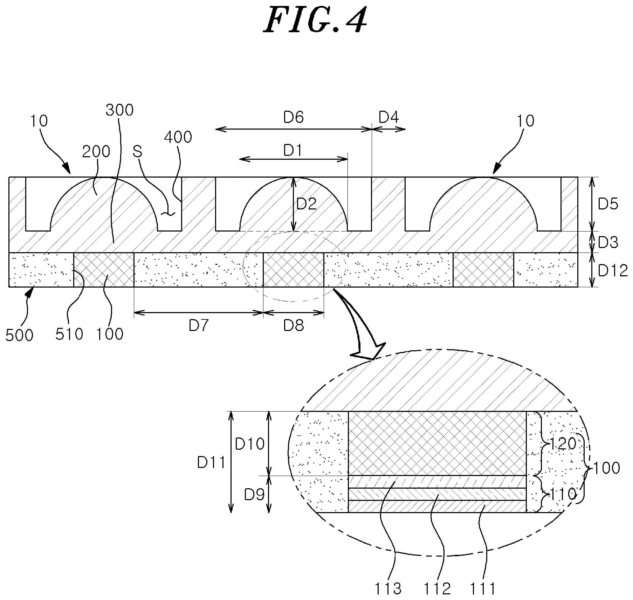

Hereinafter, the specific configuration of a display device and a light emitting module according to a first embodiment of the present disclosure will be described with reference to FIGS. 1 to 4. The first embodiment of the display device 1 according to the present disclosure can display characters, symbols, images, or videos. The display device 1 may include a plurality of light emitting modules 10, and a display substrate 20.

Each of the plurality of light emitting modules 10 can generate light. The plurality of light emitting modules 10 may be arranged adjacent to each other and each may generate light. For example, the plurality of light emitting modules 10 may be arranged in N rows and M columns, each generating light. In other words, the plurality of light emitting modules 10 may be arranged in an N$\times$M matrix and each may generate light. In this case, N, the number of rows of the plurality of light emitting modules 10, and M, the number of columns of the plurality of light emitting modules 10, may be the same or different. The plurality of light emitting modules 10 may be disposed on the display substrate 20. In addition, the plurality of light emitting modules 10 may be electrically connected to an electric circuit disposed on the display substrate 20. The light emitting module 10 may include a light emitting device 100, a lens 200, a lens support member 300, a partition member 400, and an element support member 500.

The light emitting device 100 can generate light. The light emitting device 100 is electrically connected to the electric circuit of the display substrate 20 and can generate light by receiving electricity from the outside through the electric circuit. A width D8 of the light emitting device 100 may be less than or equal to a width D1 of the bottom of the lens 200. A height D11 of the light emitting device 100 may be smaller than a height D12 of the element support member 500. The light emitting device 100 may include a light emitting diode chip 110, and a light-transmissive substrate 120.

The light emitting diode chip 110 can generate light. The light emitting diode chip 110 may include a P-type semiconductor and an N-type semiconductor. The P-type semiconductor may be connected to an anode of a power source through the electrical circuit of the display substrate 20. The N-type semiconductor may be connected to a cathode of the power source through the electric circuit of the display substrate 20. In addition, when electricity is supplied to the P-type semiconductor of the light emitting diode chip 110 and the N-type semiconductor of the light emitting diode chip 110 through a power source and an electric circuit, the light emitting diode chip 110 can generate light. A plurality of the light emitting diode chips 110 may be provided. The plurality of light emitting diode chips 111, 112, and 113 may be electrically connected to the electrical circuit of the display substrate 20.

The light emitting diode chip 110 may have a small size. For example, the light emitting diode chip 110 may be a micro LED with a side length of 200 $\mu$m or less. In addition, the light emitting diode chip 110 can self-emit light in various colors such as red, green, or blue, and can function as a pixel as a light emitting source rather than a backlight.

At least some of the plurality of light emitting diode chips 111, 112, and 113 may generate light with a different peak wavelength from those of other light emitting diode chips. For example, the plurality of light emitting diode chips 111, 112, and 113 may include a first light emitting diode chip 111 that generates red light, a second light emitting diode chip 112 that generates green light, and a third light emitting diode chip 113 that generates blue light. The plurality of light emitting diode chips 111, 112, and 113 may be arranged upwardly. For example, when the light emitting diode chip 110 includes the first light emitting diode chip 111, the second light emitting diode chip 112, and the third light emitting diode chip 113, the first light emitting diode chip 111 is disposed at the bottom, the second light emitting diode chip 112 is disposed above the first light emitting diode chip 111, and the third light emitting diode chip 113 is disposed above the second light emitting diode chip 112. However, the present disclosure is not limited to the above, and the second light emitting diode chip 112 may be disposed adjacent to a side surface of the first light emitting diode chip 111, and the third light emitting diode may be disposed adjacent to a side surface of the second light emitting diode chip 112.

A height D9 of the light emitting diode chip 110 may be smaller than a height D3 of the lens support member 300. In other words, the height D3 of the lens support member 300 may be greater than the height D9 of the light emitting diode chip 110.

The light-transmissive substrate 120 may be disposed above the light emitting diode chip 110. The light-transmissive substrate 120 can transmit light generated from the light emitting diode chip 110. For example, the light-transmissive substrate 120 may include silicone, silicon oxide ($SiO_2$), or sapphire. In addition, the light-transmissive substrate 120 may be formed of a material having a refractive index smaller than that of the light emitting diode chip 110.

A height D10 of the light-transmissive substrate 120 may be greater than the height D3 of the lens support member 300. In other words, the height D3 of the lens support member 300 may be smaller than the height D10 of the light-transmitting substrate 120. When the height D3 of the lens support member 300 is smaller than the height D10 of the light-transmitting substrate 120, the light passing through the lens support member 300 is more restrained from spreading horizontally in the lens support member 300.

The refractive index of the light-transmissive substrate 120 may be greater than the refractive index of the lens 200 and the refractive index of the lens support member 300. The light-transmissive substrate 120 can transmit light generated from the plurality of light emitting diode chips 111, 112, and 113. In addition, light passing through the light-transmitting substrate 120 may sequentially pass through the lens support member 300 and the lens 200. When the refractive index of the light-transmissive substrate 120 is greater than those of the lens 200 and the lens support member 300, the light generated from the plurality of light emitting diode chips 111, 112, and 113 can be transmitted through the light-transmissive substrate 120 and collected while passing through the lens support member 300. In addition, the beam angle of light transmitted through the light-transmitting substrate 120 may be smaller than the beam angle of light generated from the plurality of light emitting diode chips 111, 112, and 113.

Meanwhile, the light-transmissive substrate 120 may not be included in the light emitting device 100. In other words, the light emitting device 100 may include the light emitting diode chip 110 without including the light-transmissive substrate 120.

The lens 200 may converge light generated from the light emitting device 100. The lens 200 is disposed above the light emitting device 100 and may have an upwardly convex shape. The lens 200 can improve the luminance of light generated from the light emitting device 100. In addition, the beam angle of light transmitted through the lens 200 may be smaller than the beam angle of light generated from the light emitting device 100. For example, the lens 200 can narrow the beam angle of light generated from the light emitting device 100 to 4/5 or less and emit it to the outside. The beam angle of light generated from the light emitting device 100 and the beam angle of light emitted through the lens 200 may differ by 20 degrees or more. As a more detailed example, the beam angle of light generated from the plurality of light emitting diode chips 111, 112, and 113 of the light emitting device 100 may be 120 degrees, and the beam angle of the light generated by the plurality of light emitting diode chips 111, 112, and 113 of the light emitting device 100 and transmitted through the lens 200 may be 100 degrees or less. The lens 200 may be formed integrally with the lens support member 300 and the partition member 400. For example, the lens 200 may be formed of silicone together with the lens support member 300 and the partition member 400. The width D1 of the bottom of the lens 200 and the height D2 of the lens 200 may be greater than the height D3 of the lens support member 300. In other words, the height D3 of the lens support member 300 may be smaller than the width D1 of the bottom of the lens 200 and the height D2 of the lens 200. When the height D3 of the lens support member 300 is smaller than the width D1 of the bottom of the lens 200 and the height D2 of the lens 200, the horizontal spreading of light from the lens support member 300 can be more restrained while the lens support member 300 supports the lens 200.

The width D1 of the bottom of the lens 200 may be greater than or equal to a width D4 of the partition member 400. In other words, the width D4 of the partition member 400 may be smaller than the width D1 of the lens 200. In addition, the distance between neighboring light emitting modules 10 can be further reduced.

The height D2 of the lens 200 may be less than or equal to a height D5 of the partition member 400. In addition, the lens 200 can improve the luminance of the light emitting module 10 by reducing the beam angle of the transmitted light.

The bottom of the lens 200 may be in contact with or spaced apart from the bottom of the partition member 400. For example, a ratio between the width D1 of the bottom of the lens 200 and a width D6 of a lens accommodation space S formed by the partition member 400 and in which the lens 200 is accommodated may be 1:1 to 1:1.5 or less. The width D1 of the bottom of the lens 200 may be greater than or equal to the width D8 of the light emitting device 100. When viewed from above, the first lens 200 may be surrounded by a lens accommodation space S.

Meanwhile, the difference between the sum of a distance D7 between the light emitting devices 100 and the width D8 of the light emitting devices 100, and the sum of the width D6 of the lens accommodation space S and the width D4 of the partition member 400 may be 20% or less compared to either value. For example, the sum of the spacing D7 between the light emitting devices 100 and the width D8 of the light emitting devices 100, the difference between the sum of the width D6 of the lens accommodation space S and the width D4 of the partition member 400 may be 20% or less of the sum of the distance D7 between the light emitting devices 100 and the width D8 of the light emitting devices 100. In addition, the difference between the distance between the centers of the light emitting devices 100 of neighboring light emitting modules 10 and the center of the partition member 400 of the neighboring light emitting modules 10 may be 20% or less of either value. Further, the difference between the distance between the centers of the lenses 200 of neighboring light emitting modules 10 and the center of the partition member 400 of the neighboring light emitting modules 10 may be 20% or less of either value. In addition, the difference between the distance between the centers of the light emitting devices 100 of neighboring light emitting modules 10 and the centers of the lenses 200 of the neighboring light emitting modules 10 may be 20% or less of either value.

The lens support member 300 supports the lens 200 and allows light to pass therethrough. The lens support member 300 is disposed between the light emitting device 100 and the lens 200 to support the lens 200, and allows light generated from the light emitting device 100 to pass therethrough. The lens support member 300 may also support the partition member 400. The lens support member 300 may be formed integrally with the lens 200 and the partition member 400. For example, the lens support member 300 may be formed of the same material as the lens 200 and the partition member 400. Therefore, separation between the lens 200 and the partition member 400 due to heat generated from the light emitting module 10 can be prevented. However, the present disclosure is not necessarily limited to the above, and the lens 200 and the partition member 400 may be formed of different materials depending on the optical profile to be implemented. The height D3 of the lens support member 300 may be smaller than the width D1 of the bottom of the lens 200 and the height D2 of the lens 200. In addition, the height D3 of the lens support member 300 may be smaller than the height D10 of the light-transmitting substrate 120 of the light emitting device 100. Further, the height D3 of the lens support member 300 may be greater than the height D9 of the light emitting diode chip 110 of the light emitting device 100. The height D3 of the lens support member 300 may be greater than the height D9 of the light emitting diode chip 110 and smaller than the height D10 of the light-transmitting substrate 120. When the height D3 of the lens support member 300 is greater than the height D9 of the light emitting diode chip 110 and less than the height D10 of the light-transmitting substrate 120, the light passing through the lens support member 300 can be further suppressed from spreading horizontally in the lens support member 300.

The lens support member 300 may be formed integrally with the lens support members 300 of other neighboring light emitting modules 10. In addition, when the lens support member 300 is formed integrally with the lens 200 and the partition member 400, the lenses 200, the lens support members 300, and the partition members 400 of at least some of the plurality of light emitting modules 10 may be formed integrally with each other.

Although not shown, a coupler may be disposed on a lower surface of the lens support member 300. The coupler may be disposed between the lens support member 300 and the light emitting device 100 to connect them to each other. When viewed in longitudinal section, the roughness of the lower surface of the lens support member 300 and the roughness of an upper surface of the light emitting device 100 may be different from each other, and the coupler may compensate for the difference in roughness to connect the lens support member 300 and the light emitting device 100 without causing a gap between the interfaces. The coupler may extend outward from the upper surface of the light emitting device 100 to the upper surface of the element support member 500, which will be described later. Accordingly, the light emitting device 100 and the element support member 500 may share the coupler. The thickness of the coupler may be thinner than the thickness of the lens support member 300 and may be thinner than the thickness of the element support member 500. The coupler may be formed of a light-transmissive material, for example, silicone.

The partition member 400 may reflect light that has passed through the lens 200. The partition member 400 can reduce the beam angle of light passing through the lens 200. In addition, mixing of light generated from the light emitting module 10 with light generated from other neighboring light emitting modules 10 can be further suppressed. Further, the resolution of the light emitting module 10 can be improved. In addition, a high-resolution display device 1 can be implemented with a small-sized light emitting device 100. The partition member 400 may extend in the up-down direction to surround at least a portion of the lens 200. The partition member 400 may extend upward from the lens support member 300 around the bottom of the lens 200 to form a lens accommodation space S in which the lens 200 is accommodated. The portion of the lens accommodating space S other than the portion in which the lens 200 is accommodated may be filled with air or a material with a lower refractive index than that of the lens 200. The partition member 400 may be formed integrally with the lens 200 and the lens support member 300. For example, the partition member 400 may be formed of silicon together with the lens 200 and the lens support member 300.

The width D4 of the partition member 400 may be less than or equal to the width D1 of the bottom of the lens 200. In addition, the height D5 of the partition member 400 may be greater than or equal to the height D2 of the lens 200. Such a partition member 400 can reflect more light. Further, the beam angle of light passing through the lens 200 becomes smaller, so the luminance of the light emitting module 10 can be improved. In addition, the width D4 of the partition member 400 may be less than or equal to the height D5 of the partition member 400.

The element support member 500 may support the light emitting device 100. The element support member 500 may be disposed lower than the lens support member 300. In addition, an element support hole 510 may be formed in the element support member 500. The light emitting device 100 may be inserted into and supported by the element support hole 510, and the light emitting device 100 may be surrounded by the element support hole 510. The element support member 500 may be bonded to the lens support member 300 by the coupler. Further, the element support member 500 may be black in color. In addition, the element support member 500 can prevent light generated from the light emitting device 100 from spreading to other neighboring light emitting modules 10. Further, the resolution of the light emitting module 10 can be improved. The height D12 of the element support member 500 may be greater than the height D11 of the light emitting device 100.

The display substrate 20 may have an electric circuit disposed thereon. A plurality of light emitting modules 10 may be arranged on the display substrate 20 to be connected to the electric circuit. The electrical circuit of the display substrate 20 is electrically connected to the plurality of light emitting diode chips 111, 112, and 113 of each of the plurality of light emitting modules 10 to supply electricity to the plurality of light emitting diode chips 111, 112, and 113. For example, the display substrate 20 may be a printed circuit board (PCB) on which an electric circuit is printed. In addition, the display substrate 20 may be a thin-film transistor (TFT) backplane.

Meanwhile, in addition to such configurations, according to a second embodiment of the present disclosure, the plurality of light emitting diode chips 111, 112, and 113 may be arranged laterally.

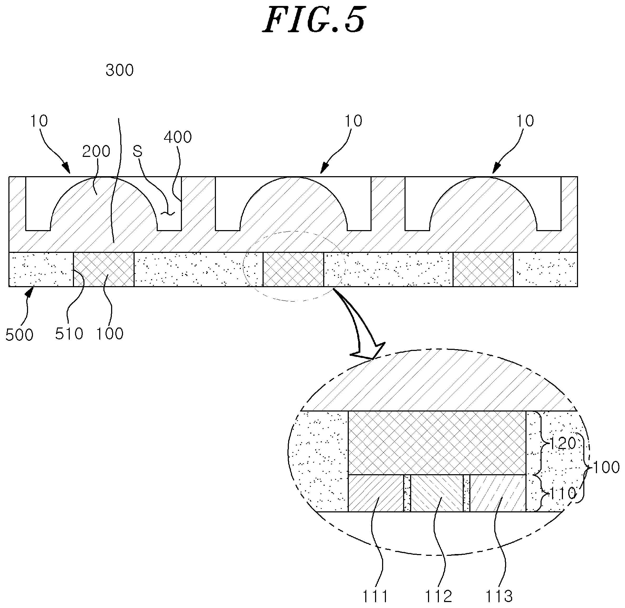

Hereinafter, the second embodiment will be described with reference to FIG. 5. In describing the second embodiment of the present disclosure, the second embodiment differs from the above-described first embodiment in that a plurality of light emitting diode chips 111, 112, and 113 are arranged laterally, and this difference will be mainly described, and the same description and reference numerals refer to the above-described embodiments.

Referring to FIG. 5, the plurality of light emitting diode chips 111, 112, and 113 may be arranged laterally. For example, the plurality of light emitting diode chips 111, 112, and 113 include a first light emitting diode chip 111 that generates red light, a second light emitting diode chip 112 that generates green light, and a third light emitting diode chip 113 that generates blue light. In addition, the first light emitting diode chip 111 and the third light emitting diode chip 113 may be disposed on both sides of the second light emitting diode chip 112, respectively. Further, the second light emitting diode chip 112 may be aligned with the center of the lens 200. An element support member 500 may be filled between the plurality of light emitting diode chips 111, 112, and 113, and the element support members 500 may physically connect the plurality of light emitting diode chips 111, 112, and 113. The level of an outer surface of the lens 200 that overlaps in the up-down direction with the second light emitting diode chip 112 disposed at the center in the plurality of light emitting diode chips 111, 112, and 113, and the level of an outer surface of the lens 200 that overlaps in the up-down direction with the first or third light emitting diode chip may be different, and the level of the outer surface of the lens 200 that overlaps the second light emitting diode chip 112 in the up-down direction may be higher. The light emitting diode chip that emits light with the shortest or longest peak wavelength among the respective peak wavelengths of light generated by the plurality of light emitting diode chips 111, 112, and 113 may be positioned outwardly. In addition, the second light emitting diode chip 112, which emits light with a peak wavelength located between the shortest and longest peak wavelengths, may be placed in the middle, and in an area where the level of the outer surface of the lens 200 is high to increase visibility.

Meanwhile, in addition to such configurations, according to a third embodiment of the present disclosure, the width D4 of the partition member 400 may become smaller as it goes upward.

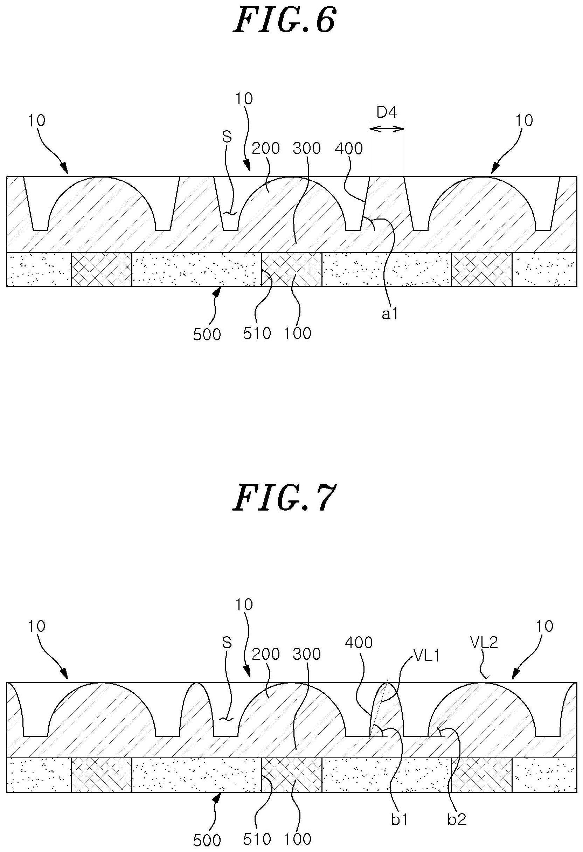

Hereinafter, the third embodiment will be described with reference to FIG. 6. In describing the third embodiment of the present disclosure, compared to the above-described embodiments, there is a difference in that the width D4 of the partition member 400 becomes smaller as it goes upward. Accordingly, this difference will be mainly discussed, and the same description and reference numerals will refer to the above-described embodiments.

Referring to FIG. 6, the width D4 of the partition member 400 may become smaller as it goes upward. In addition, the partition member 400 may have an inclined surface so that the distance between the lens 200 and the partition member 400 increases upward. An angle a1 formed by the lens support member 300 and the partition member 400 may be 60 degrees to 90 degrees. Therefore, light extraction efficiency can be increased by increasing the area filled with the material with the lowest refractive index.

Meanwhile, in addition to such configurations, according to a fourth embodiment of the present disclosure, the partition member 400 may have an upwardly convex shape.

Hereinafter, the fourth embodiment will be described with reference to FIG. 7. In describing the fourth embodiment of the present disclosure, compared to the above-described embodiments, there is a difference in that the partition member 400 has an upwardly convex shape. Accordingly, this difference will be mainly described, and the same description and reference numerals will refer to the above-described embodiments.

Referring to FIG. 7, the partition member 400 may have an upwardly convex shape. In addition, the distance between the lens 200 and the partition member 400 may gradually increase upward.

An angle b1 of a first virtual line VL1 connecting the uppermost point of the partition member 400 and the lower outer edge of the partition member 400 with respect to the lens support member 300 may be greater than an angle b2 of a second virtual line VL2 connecting the uppermost point of the lens 200 and the outer edge of the bottom of the lens 200 with respect to the lens support member 300. The curvature at the highest point of the partition member 400 may be different from the curvature at the uppermost point of the lens 200.

Meanwhile, in addition to such configurations, according to a fifth embodiment of the present disclosure, a convex portion 200-1 and a concave portion 200-2 may be formed on an upper part of the lens 200.

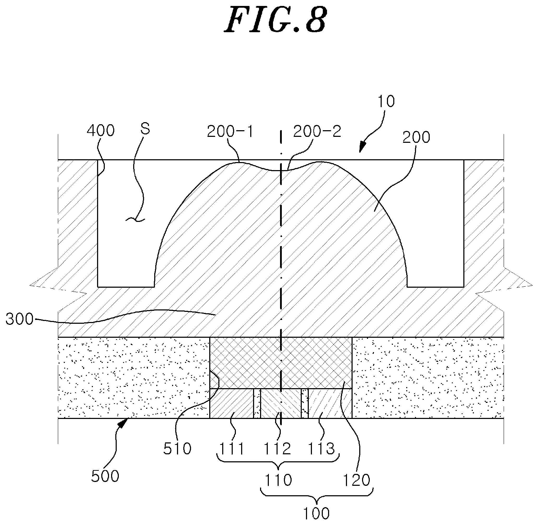

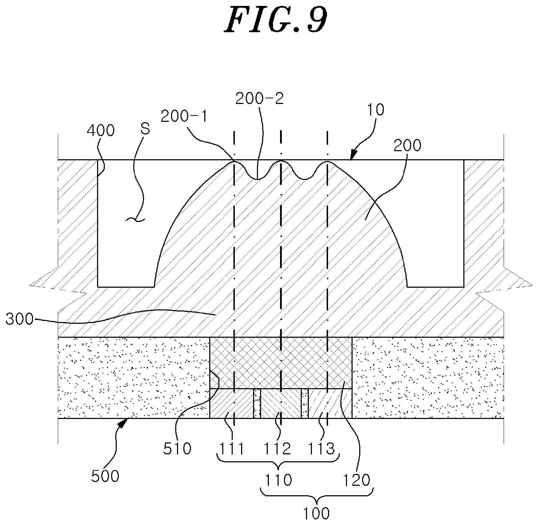

Hereinafter, the fifth embodiment will be described with reference to FIGS. 8 and 9. In describing the fifth embodiment of the present disclosure, compared to the above-described embodiments, the difference is that the convex portion 200-1 and the concave portion 200-2 are formed on the upper part of the lens 200. Accordingly, these differences will be mainly explained, and the same description and reference numerals will refer to the above-described embodiments.

Referring to FIGS. 8 and 9, the convex portion 200-1 and a concave portion 200-2 may be formed on the upper part of the lens 200.

Referring to FIG. 8, one concave portion 200-2 and two convex portions 200-1 are formed on the upper part of the lens 200, and the convex portions 200-1 are disposed on both sides of the concave portion 200-2, and the concave portion 200-2 and the convex portions 200-1 may be connected to each other.

The light emitting device 100 may include a first light emitting diode chip 111 that generates red light, a second light emitting diode chip 112 that generates green light, and a third light emitting diode chip 113 that generates blue light. In addition, the plurality of light emitting diode chips 111, 112, and 113 may be arranged laterally. In addition, the first light emitting diode chip 111 and the third light emitting diode chip 113 may be disposed on both sides of the second light emitting diode chip 112, respectively. Further, the second light emitting diode chip 112 may be arranged to be aligned with the concave portion 200-2 on the upper part of the lens 200. Further, the luminance of light generated from each of the plurality of light emitting diode chips 111, 112, and 113 may increase while passing through the lens 200. In addition, the visibility and color contrast of red, green, and blue light can be adjusted by positioning a portion of the surface of the lens 200 located on the top of the second light emitting diode chip 112, which emits green light with the highest visibility, lower than a portion of the surface of the lens 200 located on the top of the first and third light emitting diode chips 111 and 113.

Referring to FIG. 9, a plurality of convex portions 200-1 and a plurality of concave portions 200-2 are formed on the upper part of the lens 200, and the convex portions 200-1 and the concave portions 200-2 may be arranged alternately and connected to each other. For example, three convex portions 200-1 and three concave portions 200-2 are formed on the upper part of the lens 200, and the convex portions 200-1 and concave portions 200-2 may be arranged alternately and connected to each other.

The light emitting device 100 may include a first light emitting diode chip 111 that generates red light, a second light emitting diode chip 112 that generates green light, and a third light emitting diode chip 113 that generates blue light. The plurality of light emitting diode chips 111, 112, and 113 may be arranged laterally. In addition, the first light emitting diode chip 111 and the third light emitting diode chip 113 may be disposed on both sides of the second light emitting diode chip 112, respectively. Each of the plurality of light emitting diode chips 111, 112, and 113 may be aligned with the convex portion 200-1 on the top of the lens 200. In addition, the luminance of light generated from each of the plurality of light emitting diode chips 111, 112, and 113 may be increased while passing through the lens 200, and each color may be emitted to the outside more clearly.

Meanwhile, in addition to such configurations, according to a sixth embodiment of the present disclosure, the lens 200 and the lens support member 300 may be formed integrally with each other, and the partition member 400 may be formed separately from the lens 200 and the lens support member 300.

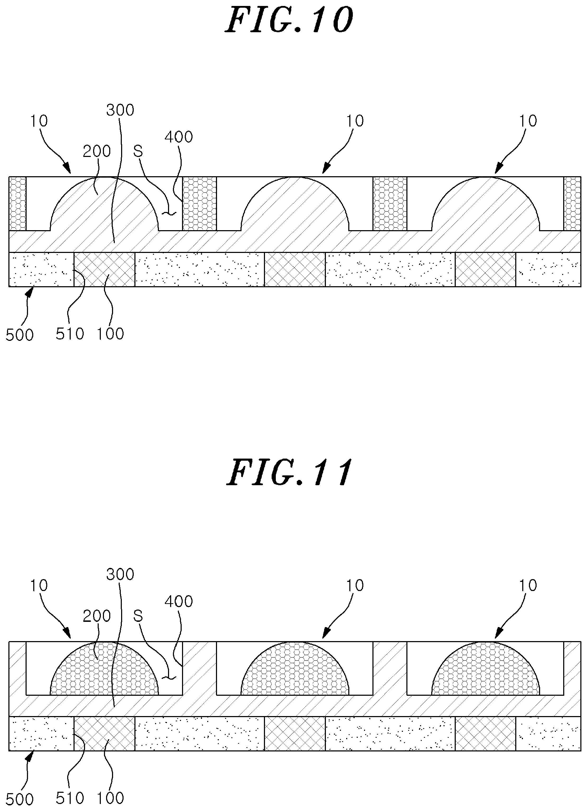

Hereinafter, the sixth embodiment will be described with reference to FIG. 10. In describing the sixth embodiment of the present disclosure, compared to the above-described embodiments, there are differences in that the lens 200 and the lens support member 300 are formed integrally with each other, and the partition member 400 is formed separately from the lens 200 and the lens support member 300. Accordingly, these differences will be mainly explained, and the same description and reference numerals will refer to the above-described embodiments.

Referring to FIG. 10, the lens 200 and the lens support member 300 may be formed integrally with each other, and the partition member 400 may be formed separately from the lens 200 and the lens support member 300. For example, by double injection, the lens 200 and the lens support member 300 may be formed integrally with each other, and the partition member 400 may be formed separately from the lens 200 and the lens support member 300.

The partition member 400 is formed of a material different from that of the lens 200 and the lens support member 300, so that the reflectance of the partition member 400 may be different from the reflectance of the lens 200 and the reflectance of the lens support member 300. For example, the lens 200 and the lens support member 300 may be made of silicon, and the partition member 400 may be made of a material with a higher reflectivity than silicon. In addition, the partition member 400 may be formed of a material different from that of the lens 200 or the lens support member 300, so that the thermal expansion coefficient of the partition member 400 is different from the thermal expansion coefficient of the lens 200 or the lens support member 300, thereby reducing deformation of the lens 200, the lens support member 300, and the partition member 400 due to heat generated from the light emitting module 10.

Meanwhile, in addition to such configurations, according to a seventh embodiment of the present disclosure, the lens support member 300 and the partition member 400 may be formed integrally with each other, and the lens 200 may be formed separately from the lens support member 300 and the partition member 400.

Hereinafter, the seventh embodiment will be described with reference to FIG. 11. In describing the seventh embodiment of the present disclosure, compared to the above-described embodiments, there is a difference in that the lens support member 300 and the partition member 400 are formed integrally with each other, and the lens 200 is formed separately from the lens support member 300 and the partition member 400. Accordingly, this difference will be mainly explained, and the same description and reference numerals will refer to the above-described embodiments.

Referring to FIG. 11, the lens support member 300 and the partition member 400 may be formed integrally with each other, and the lens 200 may be formed separately from the lens support member 300 and the partition member 400. For example, by double injection, the lens support member 300 and the partition member 400 may be formed integrally with each other, and the lens 200 may be formed separately from the lens support member 300 and the partition member 400.

The lens 200 may be made of a material different from that of the lens support member 300 and the partition member 400, so that the refractive index of the lens 200 and that of the lens support member 300 may be different. For example, the lens 200 may be made of high refractive index plastic, which has a higher refractive index than silicon, and the lens support member 300 and the partition member 400 may be made of silicon. In addition, the thermal expansion coefficient of the lens 200 and the thermal expansion coefficient of the partition member 400 or the lens support member 300 may be different to reduce deformation of the lens 200, the lens support member 300 and the partition member 400 due to heat generated from the light emitting module 10.

Meanwhile, in addition to such configurations, according to an eighth embodiment of the present disclosure, a light-transmitting layer 600 may be further included.

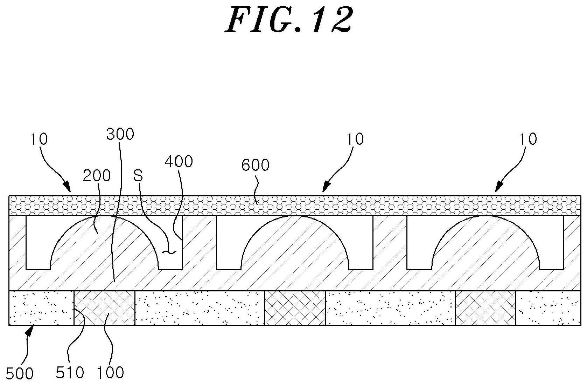

Hereinafter, the eighth embodiment will be described with reference to FIG. 12. In describing the eighth embodiment of the present disclosure, compared to the above-described embodiments, there is a difference in that the light-transmitting layer 600 is further included. Accordingly, this difference will be mainly described, and the same description and reference numerals will refer to the above-described embodiments.

Referring to FIG. 12, the light-transmitting layer 600 may be further included. The light-transmitting layer 600 may be supported on the partition member 400 to cover the open upper part of a lens accommodation space S. The light-transmitting layer 600 may be adhered to the partition member 400 using a transparent adhesive. The light-transmitting layer 600 may be formed integrally with the light-transmitting layer 600 of another neighboring light emitting module 10. In other words, at least some of the light-transmitting layers 600 of the plurality of light emitting modules 10 may be formed integrally. The light-transmitting layer 600 may be black. For example, the light-transmitting layer 600 may be formed of polyethylene terephthalate (PET).

The lens accommodation space S may be filled with a material that has a lower refractive index than the materials disposed around to form the lens accommodation space S. Thus, the light emitted from the lens 200 may be subjected to increase lateral refraction due to the lower refractive index of the lens accommodation space S, and spread inside the lens accommodation space S so that the light is uniformly incident on an upper region of the light-transmitting layer 600 that overlaps the lens accommodation space S in an up-down direction and emitted to the outside.

The light-transmitting layer 600 may transmit light generated from the light emitting device 100 and transmitted through the lens 200. In addition, the light-transmitting layer 600 may be black when light is not transmitted through the light-transmitting layer 600.

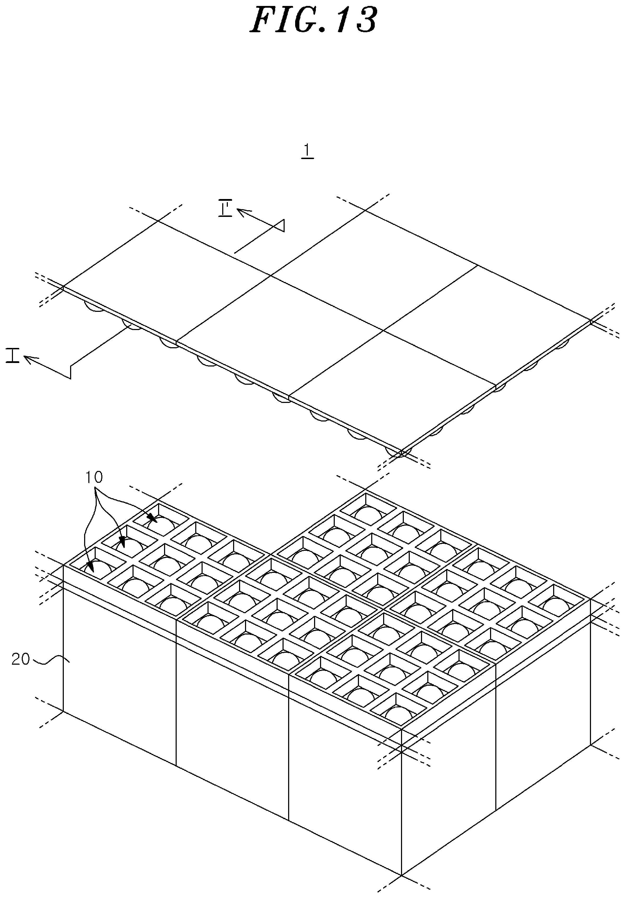

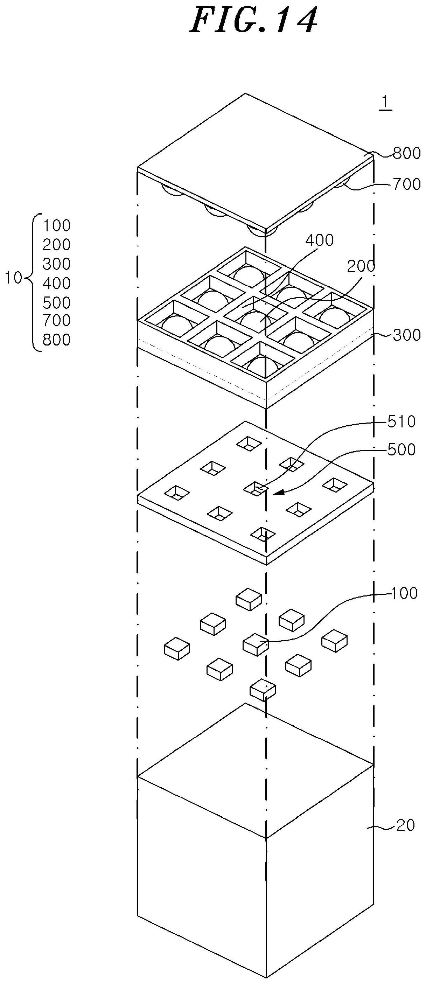

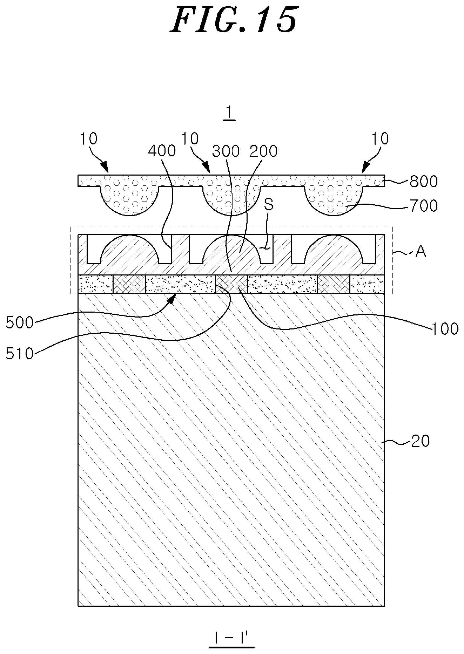

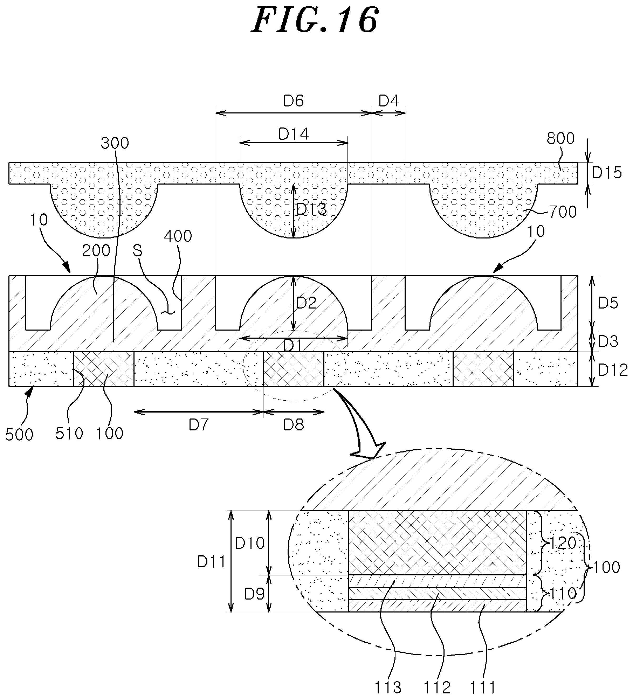

Hereinafter, with reference to FIGS. 13 to 16, the specific configuration of the light emitting module 10 and the display device 1 including the same according to the ninth embodiment of the present disclosure will be described. Further, in describing the ninth embodiment, there is a difference in that the second lens 700 and the second lens support member 800 may be further included when compared to the above-described embodiments, and this difference will be mainly explained. The lens 200 described in the previous embodiment may be referred to as the first lens 200, and the lens support member 300 may be referred to as the first lens support member 300. Further, the width D1 of the bottom of the first lens 200 may be referred to as the diameter D1 of the first lens 200. The radius x1 and the height D2 of the first lens 200 may be formed at a ratio of 1:1 to 1:3.

The second lens 700 may collect light that has passed through the first lens 200. The second lens 700 may be disposed above the first lens 200 and may have a downwardly convex shape, but is not limited thereto. The second lens 700 can improve the luminance of light generated from the first lens 200. In addition, the beam angle of light passing through the second lens 700 may be smaller than the beam angle of light passing through the first lens 200. The second lens 700 may be arranged to be spaced apart from the first lens 200. A separation distance L1 between the second lens 700 and the first lens 200 in an up-down direction may be smaller than a height D13 of the second lens 700 and the height D2 of the first lens 200.

Meanwhile, an air layer may be formed between the second lens 700 and the first lens 200, but the present disclosure is not limited thereto, and a light-transmitting layer (not shown) through which light can transmit may be provided. For example, the light-transmitting layer may be formed of silicone.

The top of the second lens 700 may be supported on the second lens support member 800. The second lens 700 may be formed integrally with the second lens support member 800. For example, the second lens 700 may be formed of silicone, together with the second lens support member 800.

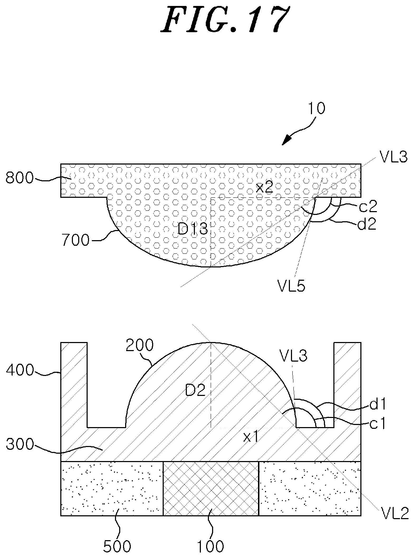

Referring further to FIG. 17, a width D14 of the top of the second lens 700 may be equal to or larger than the width D1 of the bottom of the first lens 200. The width D14 of the top of the second lens 700 may be referred to as the diameter of the second lens 700. In other words, a radius x2 of the second lens 700 may be larger than the radius x1 of the first lens 200. In addition, the height D13 of the second lens 700 may be equal to or smaller than the height D2 of the first lens 200. The curvature of the second lens 700 may be the same as or smaller than that of the first lens 200. The radius x1 and height D13 of the second lens 700 may be formed in a ratio of 1:1 to 1:3, but the present disclosure is not limited thereto.

In addition, a first angle c1 of a second virtual line VL2 connecting the uppermost point of the first lens 200 and the outer edge of the bottom of the first lens 200 with respect to the first lens support member 300 and a second angle c2 of a third virtual line VL3 connecting the lowermost point of the second lens 700 and the outer edge of the top of the second lens 700 with respect to the second lens support member 800 may be formed differently from each other. In other words, the second angle c2 may be formed to be larger than the first angle c1. Further, each of the first angle c1 and the second angle c2 may be expressed as Equation 1 and Equation 2 below.

(Equation 1)

$$\tan c1 = \frac{D2}{x1}$$

(Equation 2)

$$\tan c2 = \frac{D13}{x2}$$

Further, a first tangential angle d1 of a first lens tangent VL4 passing through the outer edge of the bottom of the first lens 200 with respect to the first lens support member 300 and a second tangential angle d2 of a second lens tangent VL5 passing through the outer edge of the top of the second lens 700 with respect to the second lens support member 800 may be formed differently from each other. In other words, the second tangential angle d2 may be formed to be larger than the first tangential angle d1.

In addition, the diameter D14 of the second lens 700 and the height D13 of the second lens 700 may be greater than a height D15 of the second lens support member 800. In other words, the height D15 of the second lens support member 800 may be smaller than the diameter D14 of the second lens 700 and the height D13 of the second lens 700. When the height D15 of the second lens support member 800 is smaller than the diameter D14 of the second lens 700 and the height D13 of the second lens 700, the horizontal spreading of light passing through the second lens support member 800 in the second lens support member 800 can be more restrained while the second lens support member 800 supports the second lens 700. Further, the height D15 of the second lens support member 800 may be equal to or smaller than the height D3 of the first lens support member 300.

The second lens support member 800 may allow light transmitted through the second lens 700 to be transmitted while supporting the second lens 700. The second lens support member 800 may be disposed on the upper side of the second lens 700. The second lens support member 800 may be formed integrally with the second lens 700. For example, the second lens support member 800 may be formed of the same material as the second lens 700. The height D15 of the second lens support member 800 may be smaller than the diameter of the second lens 700 and the height D13 of the second lens 700. The height D15 of the second lens support member 800 may be equal to or smaller than the height D3 of the first lens support member 300. The second lens support member 800 may be formed integrally with the second lens support member 800 of another neighboring light emitting module 10.

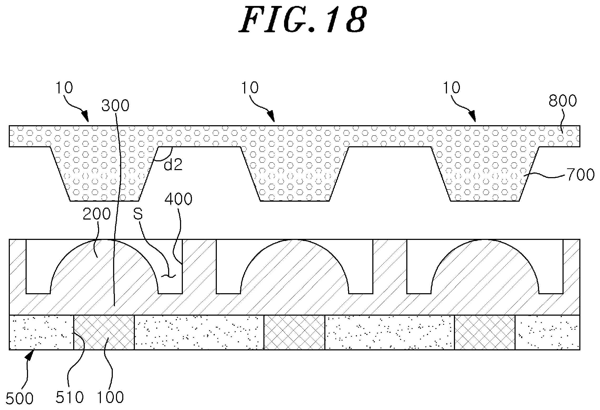

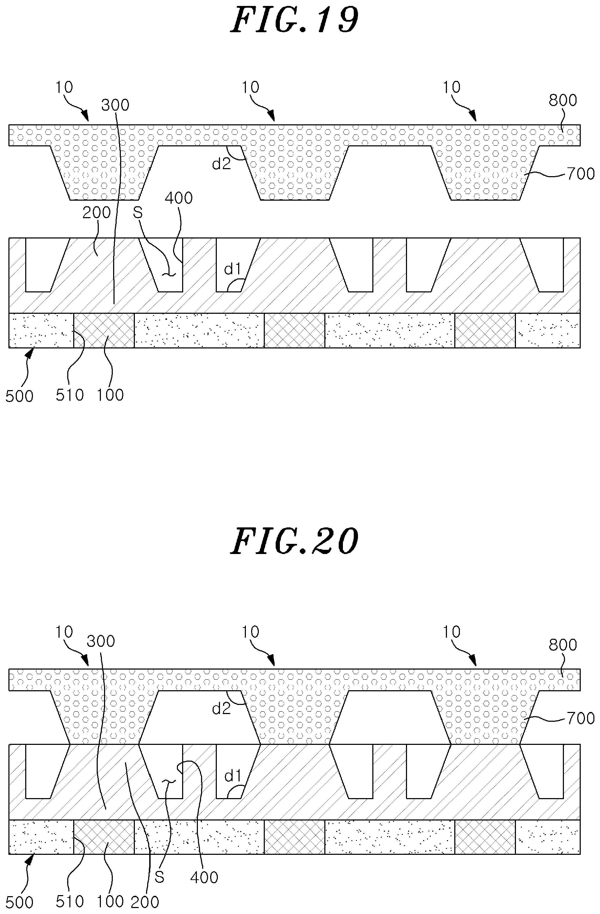

Hereinafter, with reference to FIGS. 18 and 19, the specific configuration of a light emitting module 10 and a display device 1 including the same according to a tenth embodiment of the present disclosure will be described. In describing the tenth embodiment, there is a difference in that at least one of the upper side of the first lens 200 and the lower side of the second lens 700 is flat, and this difference will be mainly described.

As a first example, the lower side of the second lens 700 may be formed as a flat surface. In other words, the lower side of the second lens 700 may be parallel to the second lens support member 800. Both side surfaces of the second lens 700 may be formed as inclined surfaces that are more spaced apart from each other toward the second lens support member 800. The second lens support member 800 and the inclined surface may form the second tangential angle d2. In addition, the first lens 200 may be formed to be convex upward. The lower side of the second lens 700 may be arranged to overlap the first lens 200 when viewed in the up-down direction.

As a second example, the upper side of the first lens 200 may be formed as a flat surface. In other words, the upper side of the first lens 200 may be parallel to the first lens support member 300. Both side surfaces of the first lens 200 may be formed as inclined surfaces that are further away from each other toward the first lens support member 300. The first lens support member 300 and the inclined surface may form the first tangential angle d1. In addition, the second lens 700 may be formed to be convex downward. The upper side of the first lens 200 may be arranged to overlap the second lens 700 when viewed in the up-down direction.

As a third example, both the upper side of the first lens 200 and the lower side of the second lens 700 may be formed as flat surfaces. The upper side of the first lens 200 may be parallel to the first lens support member 300. Both side surfaces of the first lens 200 may be formed as inclined surfaces that are more spaced apart from each other toward the first lens support member 300. In addition, the lower side of the second lens 700 may be parallel to the second lens support member 800. Both side surfaces of the second lens 700 may be formed as inclined surfaces that are more spaced apart from each other toward the second lens support member 800. The upper side of the first lens 200 and the lower side of the second lens 700 may be disposed at positions that overlap each other when viewed in the up-down direction. The horizontal lengths of the upper side of the first lens 200 and the lower side of the second lens 700 may be the same, but are not limited thereto.

Hereinafter, with reference to FIG. 20, the specific configuration of a light emitting module 10 and a display device 1 including the same according to an eleventh embodiment of the present disclosure will be described. In describing the third embodiment, there is a difference in that the first lens 200 and the second lens 700 may have configurations in which they are in contact with each other, and this difference will be mainly described.

The upper side of the first lens 200 and the lower side of the second lens 700 may contact each other. The upper side of the first lens 200 and the lower side of the second lens 700 may overlap each other when viewed in the up-down direction. The upper side of the first lens 200 and the upper side of the second lens 700 may be formed as a flat surface, but are not limited thereto. In addition, the first lens 200 and the second lens 700 may be formed in a convex shape toward each other, and the upper side of the first lens 200 and the lower side of the second lens 700 may be in contact.

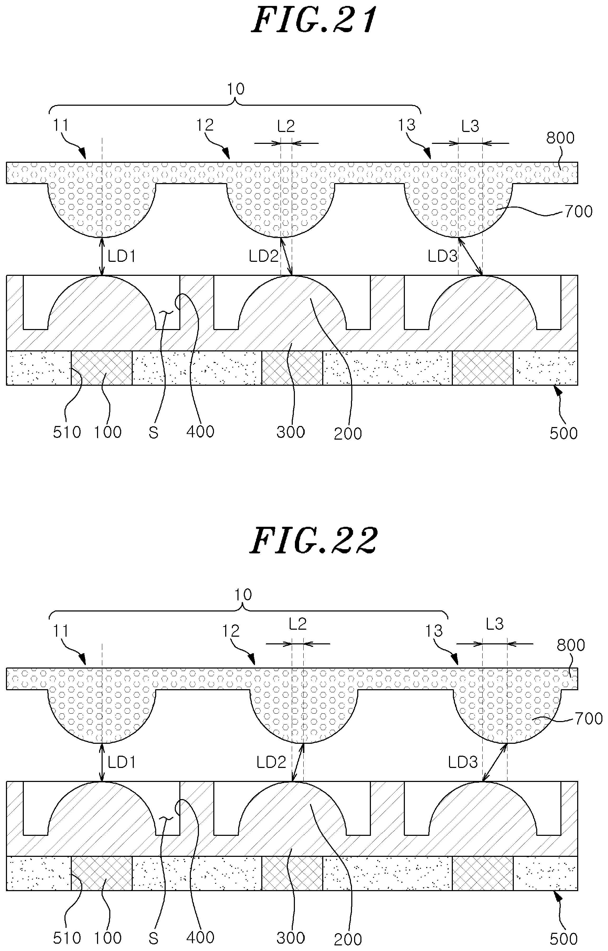

Hereinafter, with reference to FIGS. 21 and 22, the specific configuration of a light emitting module 10 and a display device 1 including the same according to a twelfth embodiment of the present disclosure will be described. In describing the twelfth embodiment, there is a difference in that the first lens 200 and the second lens 700 at least one of the plurality of light emitting modules 10 may be arranged and shaped so that their central axes coincide with each other when viewed in the up-down direction, and this difference will be mainly described.

The first lenses 200 and the second lenses 700 of one of the plurality of light emitting modules 10 may be arranged so that their central axes coincide with each other when viewed in the up-down direction. The central axis may be an axis that extends in the up-down direction and passes through the center of the diameter of the lens and the highest point of the lens.

In addition, when viewed in the up-down direction, the first lenses 200 and the second lens 700 of another one of the plurality of light emitting modules 10 may be arranged so that their central axes are spaced apart from each other to form center separation distances L2, L3. The center separation distances L2, L3 may be the horizontal separation distances between the central axis of the first lens 200 and the central axis of the second lens 700. The shortest straight-line distance LD2, LD3 between the first lens 200 and the second lens 700 of another one of the plurality of light emitting modules 10 may be greater than the shortest straight-line distance LD1 between the first lens 200 and the second lens 700 of the one of the plurality of light emitting modules 10.

The first lens 200 and the second lens 700 may be arranged such that as the shortest straight-line distances LD1, LD2, and LD3 increase, the center separation distances L2, L3 also increase. The first lens 200 and the second lens 700 may be arranged such that as the shortest straight-line distances LD1, LD2, LD3 increase, the width of the overlapping area projected directly above between the first lens 200 and the second lens 700 becomes smaller and the width of the non-overlapping area becomes larger. In addition, the first lens 200 and the second lens 700 may be arranged such that as the shortest straight-line distances LD1, LD2, and LD3 decrease, the center separation distances L2 and L3 decrease. The first lens 200 and the second lens 700 may be arranged such that as the shortest straight-line distances LD1, LD2, LD3 decrease, the width of the overlapping area projected directly above between the first lens 200 and the second lens 700 becomes larger and the width of the non-overlapping area becomes smaller. Hereinafter, the area that overlaps when the first lens 200 and the second lens 700 are projected directly above therebetween is referred to as the overlapping area, and the area that is not overlapped when the first lens 200 and the second lens 700 are projected directly above therebetween is referred to as the non-overlapping area.

The plurality of light emitting modules 10 may include a first light emitting module 11, a second light emitting module 12, and a third light emitting module 13.

The first light emitting module 11 may be arranged closer to the center of the display substrate 20 than the second light emitting module 12 and the third light emitting module 13. The center of the display substrate 20 may be the center of the display device 1. For example, the first light emitting module 11 may be arranged at the center of the display substrate 20. The first lens 200 and the second lens 700 included in the first light emitting module 11 may be arranged so that the positions of their central axes coincide with each other when viewed in the up-down direction. Hereinafter, the first lens 200 and the second lens 700 included in the first light emitting module 11 will be referred to as a first lens group. The shortest straight-line distance LD1 of the first lens group may be equal to the separation distance L1.

The second light emitting module 12 may be arranged between the first light emitting module 11 and the third light emitting module 13. For example, the second light emitting module 12 may be arranged to be further spaced from the center of the display substrate 20 than the first light emitting module 11. The first lens 200 and the second lens 700 included in the second light emitting module 12 may be arranged so that their central axes are spaced apart from each other to form the center separation distance L2. Hereinafter, the first lens 200 and the second lens 700 included in the second light emitting module 12 will be referred to as a second lens group. The shortest straight-line distance LD2 of the second lens group may be greater than the shortest straight-line distance LD1 of the first lens group. In addition, the width of the overlapping area of the second lens group may be smaller than the width of the overlapping area of the first lens group.

In addition, the central axis of one of the first lens 200 and the second lens 700 of the second lens group may be arranged closer to the first lens group than the central axis of the other of the first lens 200 and the second lens 700 of the second lens group. For example, the central axis of the second lens 700 of the second lens group may be arranged to be closer to the first lens group than the central axis of the first lens 200 of the second lens group. As another example, the central axis of the first lens 200 of the second lens group may be arranged to be closer to the first lens group than the central axis of the second lens 700 of the second lens group.

The third light emitting module 13 may be disposed closer to the edge of the display substrate 20 than the first light emitting module 11 and the second light emitting module 12. For example, the third light emitting module 13 may be disposed near the edge of the display substrate 20. The first lens 200 and the second lens 700 included in the third light emitting module 13 may be arranged so that their central axes are spaced apart from each other to form the center separation distance L3. Hereinafter, the first lens 200 and the second lens 700 included in the third light emitting module 13 will be referred to as a third lens group. The shortest straight-line distance LD3 of the third lens group may be greater than the shortest straight-line distance LD2 of the second lens group. The shortest straight-line distance LD3 of the third lens group may be greater than the shortest straight-line distance LD2 of the second lens group. In addition, the width of the overlapping area of the third lens group may be smaller than the width of the overlapping area of the second lens group. The width of the overlapping area of the first lens group may be larger than the widths of the overlapping areas of the second and third lens groups. In other words, any one of the plurality of lens groups may have a width of the overlapping area different from that of another one of the plurality of lens groups.

The central axis of any one of the first lens 200 and the second lens 700 of the third lens group may be arranged closer to the second lens group than the central axis of the other of the first lens 200 and the second lens 700 of the third lens group. For example, the central axis of the second lens 700 of the third lens group may be arranged to be closer to the second lens group than the central axis of the first lens 200 of the third lens group. As another example, the central axis of the first lens 200 of the third lens group may be arranged to be closer to the second lens group than the central axis of the second lens 700 of the third lens group.

Accordingly, luminance and color deviation depending on the viewing angle can be reduced.

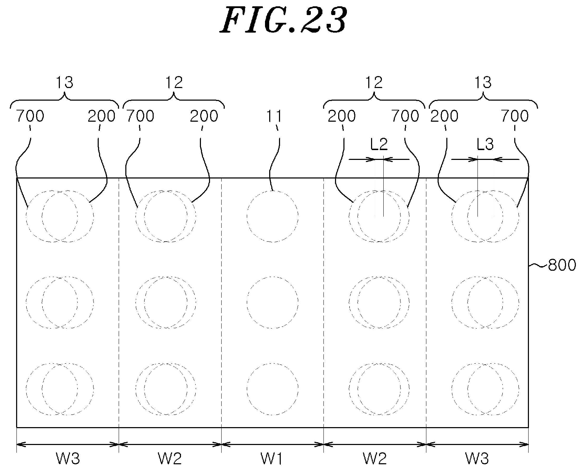

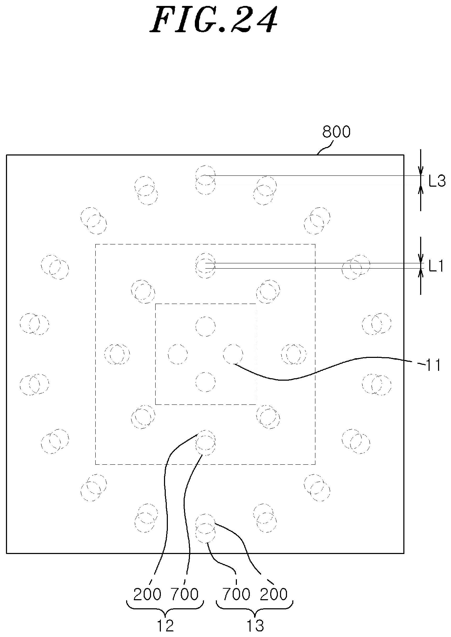

Hereinafter, with reference to FIGS. 23 and 24, the specific configuration of a light emitting module 10 and a display device 1 including the same according to a thirteenth embodiment of the present disclosure will be described. In describing the thirteenth embodiment, there is a difference in that the display substrate 20 can provide a plurality of substrate regions W1, W2, and W3, and this difference will be mainly described.

One or more light emitting modules 10 may be disposed in each of the plurality of substrate regions W1, W2, and W3. In other words, one or more lens groups may be disposed in each of the plurality of substrate regions W1, W2, and W3. The center separation distances L2, L3 of the plurality of lens groups may be formed differently for each substrate region. The plurality of substrate regions W1, W2, and W3 may be sequentially arranged from the center of the display substrate 20 toward the edge of the display substrate 20.

The plurality of substrate regions may include a first substrate region W1, a second substrate region W2, and a third substrate region W3.

The first substrate region W1 may be a region disposed at the center of the display substrate 20 among the plurality of substrate regions. As an example, the first substrate region W1 may be disposed on an inner side of the second substrate region W2 in the display substrate 20 to be located at the center of the display substrate 20. As another example, the first substrate region W1 may be a region disposed between a plurality of second substrate regions W2 in the display substrate 20. One or more first lens groups may be disposed in the first substrate region W1. In other words, the first lens 200 and the second lens 700 disposed in the first substrate region W1 may be arranged such that the positions of their central axes coincide with each other when viewed in the up-down direction.

The second substrate region W2 may be a region arranged to be further away from the center of the display substrate 20 than the first substrate region W1. As an example, the second substrate region W2 may be a region located between the first substrate region W1 and the third substrate region W3 in the display substrate 20, with the first substrate region W1 located inwardly. As another example, a plurality of second substrate regions W2 may be formed in the display substrate 20 and may be disposed on both sides of the first substrate region W1.

One or more second lens groups may be disposed in the second substrate region W2. The center separation distance of one of the plurality of second lens groups may be different from the center separation distance L2 of another one of the plurality of second lens groups. For example, one of the plurality of second lens groups may be disposed closer to the center of the display substrate 20 than another one, so that the center separation distance may be smaller than that of another one.

The third substrate region W3 may be a region disposed closer to the edge of the display substrate 20 than the first substrate region W1 and the second substrate region W2. As an example, the third substrate region W3 may be a region between the second substrate region W2 and the edge of the display substrate 20, with the second substrate region W2 disposed inwardly. As another example, a plurality of third substrate regions W3 may be formed in the display substrate 20 and may be disposed outwardly of the plurality of second substrate regions W2 so that the plurality of second substrate regions W2 are disposed inwardly.

One or more third lens groups may be disposed in the third substrate region W3. The center separation distance of one of the plurality of third lens groups may be formed differently from the center separation distance of another one of the plurality of third lens groups. For example, one of the plurality of third lens groups is disposed closer to the center of the display substrate 20 than another one of the plurality of third lens groups, so that the center separation distance thereof is smaller than the center separation distance of another one. In addition, the average of the center separation distances of the plurality of third lens groups arranged in the third substrate region W3 may be greater than the average of the center separation distances of the plurality of second lens groups arranged in the second substrate region W2.

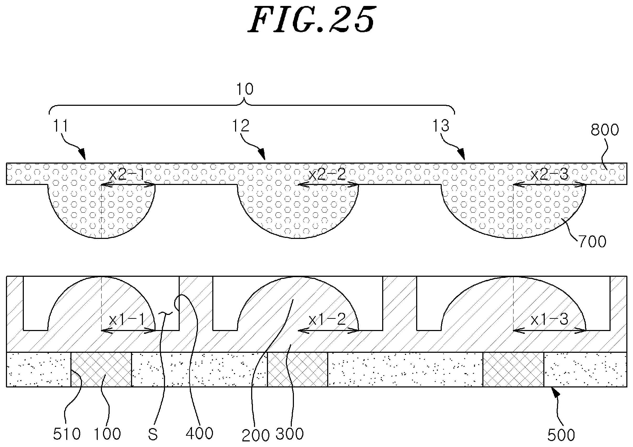

Hereinafter, with reference to FIG. 25, the specific configuration of a light emitting module 10 and a display device 1 including the same according to a fourteenth embodiment of the present disclosure will be described. In describing the fourteenth embodiment, there are differences in that a diameter of any one of the plurality of first lenses 200 may be formed differently from a diameter of another one of the plurality of first lenses 200, and a diameter of any one of the plurality of second lenses 700 may be formed differently from a diameter of another one of the plurality of second lenses 700, and these differences will be mainly described.

Among the plurality of first lenses 200, the diameter of the first lens 200 disposed at the center of the display substrate 20 may be smaller than the diameter of the first lens 200 disposed near the edge of the display substrate 20. In other words, the curvature of the first lens 200 disposed at the center of the display substrate 20 may be greater than the curvature of the first lens 200 disposed near the edge of the display substrate 20.

For example, the first lens 200 of the first group lens may have a first radius x1-1, the first lens 200 of the second group lens may have a second radius x1-2, and the first lens 200 of the third group lens may have a third radius x1-3. Since the third radius x1-3 may be formed to be larger than the second radius x1-2, the curvature of the first lens 200 of the third group lens may be formed to be smaller than the curvature of the second lens 700 of the second group lens. In addition, since the second radius x1-2 may be formed to be larger than the first radius x1-1, the curvature of the first lens 200 of the second group lens may be formed to be smaller than the curvature of the first lens 200 of the first group lens.

In addition, among the plurality of second lenses 700, the diameter of the second lens 700 disposed at the center of the display substrate 20 may be smaller than the diameter of the second lens 700 disposed near the edge of the display substrate 20. In other words, the curvature of the second lens 700 disposed at the center of the display substrate 20 may be greater than the curvature of the second lens 700 disposed near the edge of the display substrate 20.

For example, the second lens 700 of the first group lens may have a fourth radius x2-1, the second lens 700 of the second group lens may have a fifth radius x2-2, and the second lens 700 of the third group lens may have a sixth radius x2-3. Since the sixth radius x2-1 may be formed to be larger than the fifth radius x2-2, the curvature of the second lens 700 of the third group lens may be formed to be smaller than the curvature of the second lens 700 of the second group lens. In addition, since the fifth radius x2-2 may be formed to be larger than the fourth radius x2-1, the curvature of the second lens 700 of the second group lens may be formed to be smaller than the curvature of the second lens 700 of the first group lens.

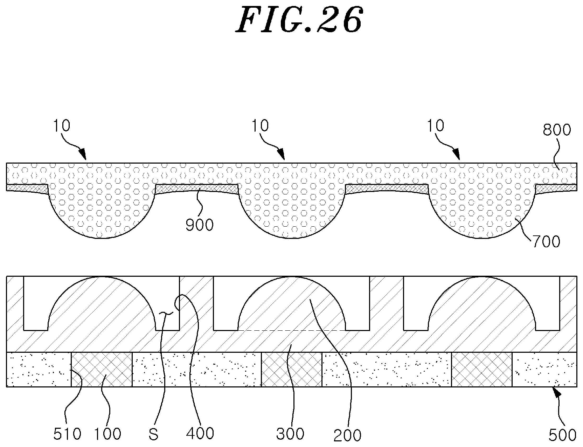

Hereinafter, with reference to FIG. 26, the specific configuration of a light emitting module 10 and a display device 1 including the same according to a fifteenth embodiment of the present disclosure will be described. In describing the fifteenth embodiment, there is a difference in that a light blocking layer 900 is further included, and this difference will be mainly described.

The light blocking layer 900 can block light. The light blocking layer 900 may be disposed on at least one of a lower surface of the second lens support member 800 and an upper surface of the first lens support member 300. In other words, the light blocking layer 900 may block light from passing through at least one of the first lens support member 300 and the second lens support member 800. In addition, the light blocking layer 900 may have a concave surface. The surface of the light blocking layer 900 may be formed to be concave inward due to surface tension when the light blocking layer 900 is manufactured.

As a first example, the light blocking layer 900 may be disposed on the lower surface of the second lens support member 800. The light blocking layer 900 may be disposed between the plurality of second lenses 600. The surface of the light blocking layer 900 may be formed to be concave toward the lower surface of the second lens support member 800.

As a second example, the light blocking layer 900 may be disposed on the upper surface of the first lens support member 300. The light blocking layer 900 may be disposed on the upper surface of the first lens support member 300 to be disposed between the first lens support member 300 and the partition member 400, or may be disposed on the upper surface of the first lens support member 300 to be disposed between the partition member 400 and the first lens 200. The surface of the light blocking layer 900 may be formed to be concave toward the upper surface of the first lens support member 300.

As a third example, the light blocking layer 900 may be disposed on the lower surface of the second lens support member 800 and the upper surface of the second lens support member 800.

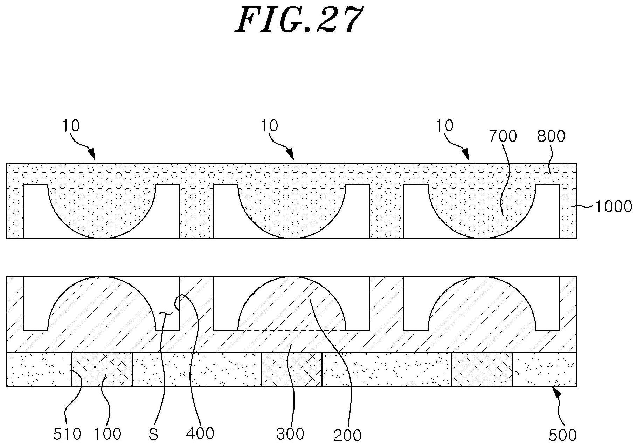

Hereinafter, with reference to FIG. 27, the specific configuration of a light emitting module 10 and a display device 1 including the same according to a sixteenth embodiment of the present disclosure will be described. In describing the eighth embodiment, there is a difference in that it further includes a partition member 900 disposed on the second lens support member 800, and this difference will be mainly described.

Hereinafter, the partition member disposed on the first lens support member 300 will be referred to as a first partition member 400, and the partition member disposed on the second lens support member 800 will be referred to as a second partition member 1000.

The second partition member 1000 can reflect light that passes through the first lens 200 and heads toward the second lens 700. The second partition member 1000 can make the beam angle of light passing through the first lens 200 smaller. In addition, mixing of light generated from the light emitting module 10 with light generated from other neighboring light emitting modules 10 can be further suppressed. Further, the resolution of the light emitting module 10 can be improved. Furthermore, a high-resolution display device 1 can be implemented with a small-sized light emitting device 100. The second partition member 1000 may extend in the up-down direction to surround at least a portion of the second lens 700. The second partition member 1000 may extend downward from the second lens support member 800 around the top of the second lens 700 to form a space in which the second lens 700 is accommodated. The portion of the accommodation space other than the area where the second lens 700 is accommodated may be filled with air or a material with a lower refractive index than that of the second lens 700. The second partition member 1000 may be formed integrally with the second lens 700 and the second lens support member 800. For example, the second partition member 1000 may be formed of silicon together with the second lens 700 and the second lens support member 800. However, the present disclosure is not necessarily limited to the above, and the second lens 700 and the second partition member 1000 may be formed of different materials depending on the optical profile to be implemented.

A width D16 of the second partition member 1000 may be smaller than the diameter D14 of the second lens 700. In addition, a height D17 of the second partition member 1000 may be greater than or equal to the height D13 of the second lens 700. Such a second partition member 1000 can reflect more light. Further, the width D16 of the second partition member 1000 may be smaller than the height D17 of the second partition member 1000. The top of the second lens 700 may be in contact with or spaced apart from the top of the second partition member 1000. For example, the ratio of the diameter D14 of the second lens 700 and the width of the space which is formed by the second partition member 1000 and in which the second lens 700 is accommodated may be 1:1 to 1:1.5 or less.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1.   A light emitting module comprising:

   a light emitting device that generates light;
   a first lens disposed above the light emitting device to collect light generated from the light emitting device; and
   a partition extending in an up-down direction to surround at least a portion of the first lens.

2.   The light emitting module of claim 1, further comprising:
   a first lens support disposed between the light emitting device and the first lens to allow light to pass therethrough while supporting the first lens.

3.   The light emitting module of claim 2, further comprising:

   a second lens disposed above the first lens to collect light passing through the first lens and having a downwardly convex shape; and
   a second lens support supporting the second lens and through which light passing through the second lens is transmitted.

4.   The light emitting module of claim 3, wherein the first lens has an upwardly convex shape, and the second lens has a downward convex shape, and
   wherein a first lens angle of a first virtual line connecting an uppermost point of the first lens and an outer edge of a bottom of the first lens with respect to the first lens support and a second lens angle of a second virtual line connecting a lowermost point of the second lens support and an outer edge of a top of the second lens with respect to the second lens support are formed differently from each other.

5.   The light emitting module of claim 2, further comprising:
   an element support disposed below the first lens support and having an element support hole through which the light emitting device is inserted and supported.

6. The light emitting module of claim 2, wherein a width of a bottom of the first lens and a height of the first lens are greater than a height of the first lens support.

7. The light emitting module of claim 3, wherein an angle of a first lens tangent passing through an outer edge of a bottom of the first lens with respect to the first lens support and an angle of the second lens tangent passing through an outer edge of a top of the second lens with respect to the second lens support are formed differently from each other.

8. The light emitting module of claim 3, wherein the first lens and the second lens are in contact with each other.

9. The light emitting module of claim 1, wherein the partition forms a lens accommodation space in which the first lens is accommodated, and
a ratio of a width of the bottom of the first lens and a width of the lens accommodation space is 1:1 to 1:1.5 or less.

10. The light emitting module of claim 3, wherein the first lens and the second lens are arranged to be spaced apart from each other.

11. The light emitting module of claim 1, wherein a width of the partition is less than or equal to a height of the partition.

12. The light emitting module of claim 2, wherein the light emitting device includes:

a light emitting diode chip that generates light; and
a light-transmissive substrate disposed above the light emitting diode chip and through which the light transmits, and
wherein a height of the first lens support is greater than a height of the light emitting diode chip,
a height of the light-transmitting substrate is greater than a height of the first lens support, and
the height of the first lens is greater than the height of the first lens support.

13. The light emitting module of claim 2, wherein the light emitting device includes:

a light emitting diode chip that generates light; and
a light-transmissive substrate through which the light transmits, and
wherein a refractive index of the light-transmitting substrate is greater than a refractive index of the first lens and a refractive index of the first lens support.

14. The light emitting module of claim 2, wherein a width of the partition becomes smaller as it goes upward.

15. The light emitting module of claim 14, wherein an angle formed by the first lens support and the partition is 60 degrees to 90 degrees.

16. The light emitting module of claim 2, wherein the partition has an upwardly convex shape, and
an angle of a first imaginary line connecting an uppermost point of the partition and an outer edge of a bottom of the partition with respect to the first lens support is greater than an angle of a second imaginary line connecting an uppermost point of the first lens and an outer edge of the bottom of the first lens with respect to the first lens support.

17. The light emitting module of claim 2, wherein the first lens, the first lens support, and the partition are formed integrally with each other.

18. The light emitting module of claim 1, wherein a convex portion and a concave portion are formed on an upper part of the first lens.

19. A display device comprising:

a light emitting device that emits light;
a lens disposed above the light emitting device to collect light generated from the light emitting device;
a first lens support disposed between the light emitting device and the first lens to support the first lens and allow the light to pass therethrough; and

a partition that extends in an up-down direction to surround at least a portion of the first lens and reflects the light,
wherein the first lens and the first lens support are formed integrally with each other, and the partition is formed separately from the first lens and the first lens support, or
the first lens support and the partition are formed integrally with each other, and the first lens is formed separately from the first lens support and the partition.

20. A display device comprising:

a display substrate on which an electrical circuit is disposed; and
a plurality of light emitting modules disposed on the display substrate to be electrically connected to the electric circuit,
wherein the light emitting module includes:

a light emitting device that generates light;
a first lens disposed above the light emitting device to collect light generated from the light emitting device;
a partition that extends in an up-down direction to surround at least a portion of the first lens and reflects the light; and
a second lens disposed above the first lens to collect light passing through the first lens.

EP 4 761 532 A1

# FIG.1

# FIG.2

# FIG.3

I – I'

# FIG.4

# FIG.5

# FIG.6

# FIG.7

# FIG.8

# FIG.9

# FIG.10

# FIG.11

# FIG.12

# FIG.13

# FIG.14

# FIG.15

I – I'

# *FIG.16*

# FIG.17

# FIG.18

# FIG.19

# FIG.20

# FIG.21

10

11    12    L2    13    L3    800

700

LD1    LD2    LD3

510  100  S  400    300  200    500

# FIG.22

10

11    12    L2    13    L3    800

700

LD1    LD2    LD3

510  100  S  400    300  200    500

# FIG.23

# FIG.24

# FIG.25

# FIG.26

# FIG.27

## INTERNATIONAL SEARCH REPORT

| International application No. |
|---|
| **PCT/KR2024/012198** |

### A. CLASSIFICATION OF SUBJECT MATTER

**H01L 25/075**(2006.01)i; **H01L 33/58**(2010.01)i; **H01L 33/48**(2010.01)i; **H01L 27/15**(2006.01)i

According to International Patent Classification (IPC) or to both national classification and IPC

### B. FIELDS SEARCHED

Minimum documentation searched (classification system followed by classification symbols)

H01L 25/075(2006.01); H01L 27/32(2006.01); H01L 33/00(2010.01); H01L 33/48(2010.01); H01L 33/50(2010.01); H01L 33/52(2010.01); H01L 33/58(2010.01); H01L 51/50(2006.01); H05B 33/22(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 발광 소자(light emitting device), 볼록 렌즈(convex lens), 격벽(partition wall), 투과(transmittance), 반사(reflection)

### C. DOCUMENTS CONSIDERED TO BE RELEVANT

| Category* | Citation of document, with indication, where appropriate, of the relevant passages | Relevant to claim No. |
|---|---|---|
| X | KR 10-2013-0035538 A (LG DISPLAY CO., LTD.) 09 April 2013 (2013-04-09)<br>See paragraphs [0023]-[0039]; and figures 1-4c. | 1-2,6,9,11,14-15,17 |
| Y | | 3,5,8,10,13,18-20 |
| A | | 4,7,12,16 |
| Y | KR 10-2335812 B1 (SAMSUNG DISPLAY CO., LTD.) 09 December 2021 (2021-12-09)<br>See paragraphs [0058]-[0063]; and figure 5. | 3,8,10,20 |
| Y | KR 10-2013-0070986 A (LG INNOTEK CO., LTD.) 28 June 2013 (2013-06-28)<br>See paragraphs [0020]-[0047]; and figure 1. | 5,18 |
| Y | KR 10-2056414 B1 (MARUBUN CORPORATION et al.) 22 January 2020 (2020-01-22)<br>See paragraphs [0008]-[0099]; and figure 2a. | 13 |

☑ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 November 2024** | **21 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/012198**

## C. DOCUMENTS CONSIDERED TO BE RELEVANT

| Category* | Citation of document, with indication, where appropriate, of the relevant passages | Relevant to claim No. |
|---|---|---|
| Y | KR 10-2020-0115537 A (V TECHNOLOGY CO., LTD.) 07 October 2020 (2020-10-07) See paragraphs [0011]-[0021]; and figures 1-2. | 19-20 |

Form PCT/ISA/210 (second sheet) (July 2022)

**INTERNATIONAL SEARCH REPORT**
Information on patent family members

International application No.

**PCT/KR2024/012198**

| Patent document cited in search report | | | Publication date (day/month/year) | Patent family member(s) | | | Publication date (day/month/year) |
|---|---|---|---|---|---|---|---|
| KR | 10-2013-0035538 | A | 09 April 2013 | None | | | |
| KR | 10-2335812 | B1 | 09 December 2021 | KR | 10-2016-0034458 | A | 30 March 2016 |
| | | | | US | 2016-0087018 | A1 | 24 March 2016 |
| | | | | US | 2017-0194400 | A1 | 06 July 2017 |
| | | | | US | 9627654 | B2 | 18 April 2017 |
| | | | | US | 9853093 | B2 | 26 December 2017 |
| KR | 10-2013-0070986 | A | 28 June 2013 | KR | 10-1896682 | B1 | 10 September 2018 |
| KR | 10-2056414 | B1 | 22 January 2020 | CN | 108292695 | A | 17 July 2018 |
| | | | | CN | 108292695 | B | 22 January 2021 |
| | | | | EP | 3346509 | A1 | 11 July 2018 |
| | | | | EP | 3346509 | A4 | 17 April 2019 |
| | | | | EP | 3346509 | B1 | 30 June 2021 |
| | | | | JP | 6230038 | B2 | 15 November 2017 |
| | | | | KR | 10-2018-0032638 | A | 30 March 2018 |
| | | | | TW | 201724552 | A | 01 July 2017 |
| | | | | TW | I637530 | B | 01 October 2018 |
| | | | | US | 10680134 | B2 | 09 June 2020 |
| | | | | US | 10950751 | B2 | 16 March 2021 |
| | | | | US | 2018-0248075 | A1 | 30 August 2018 |
| | | | | US | 2020-0313041 | A1 | 01 October 2020 |
| | | | | WO | 2017-038961 | A1 | 09 March 2017 |
| KR | 10-2020-0115537 | A | 07 October 2020 | CN | 111684511 | A | 18 September 2020 |
| | | | | JP | 2019-135738 | A | 15 August 2019 |
| | | | | TW | 201937720 | A | 16 September 2019 |
| | | | | US | 2020-0411588 | A1 | 31 December 2020 |
| | | | | WO | 2019-151066 | A1 | 08 August 2019 |

Form PCT/ISA/210 (patent family annex) (July 2022)